# EUROPÄISCHE PATENTSCHRIFT

(11) **EP 1 107 456 B1**
(45) Veröffentlichungstag und Bekanntmachung des Hinweises auf die Patenterteilung: **03.01.2007**
(21) Anmeldenummer: 00124958.0
(22) Anmeldetag: 16.11.2000
(51) Int. Cl.: H03L 7/10, H03L 7/189, H03L 7/099

(54) **Verfahren zum Regeln der von einem frequenzsteuerbaren Oszillator abgegebenen Ausgangsfrequenz**
Method for adjusting the output frequency generated by a controllable frequency oscillator
Procédé de réglage de la fréquence de sortie fournie par un oscillateur à fréquence commandée

(30) Priorität: 03.12.1999 DE 19959265
(43) Veröffentlichungstag der Anmeldung: 13.06.2001
(73) Patentinhaber: DeTeWe Systems GmbH, 10997 Berlin (DE)
(72) Erfinder: Schulz, Hans-Jürgen, Dipl.-Ing., 12051 Berlin (DE)
(74) Vertreter: Ninnemann, Detlef

(56) Entgegenhaltungen:
- EP-A- 0 910 170
- US-A- 4 677 394
- US-A- 5 331 292
- US-A- 5 382 922
- US-A- 5 894 246

## Beschreibung

Die Erfindung bezieht sich auf ein Verfahren zum Regeln der von einem frequenzsteuerbaren Oszillator abgegebenen Ausgangsfrequenz gemäß dem Oberbegriff des Anspruchs 1 sowie auf einen frequenzsteuerbaren Oszillator gemäß dem Oberbegriff des Anspruchs 9.

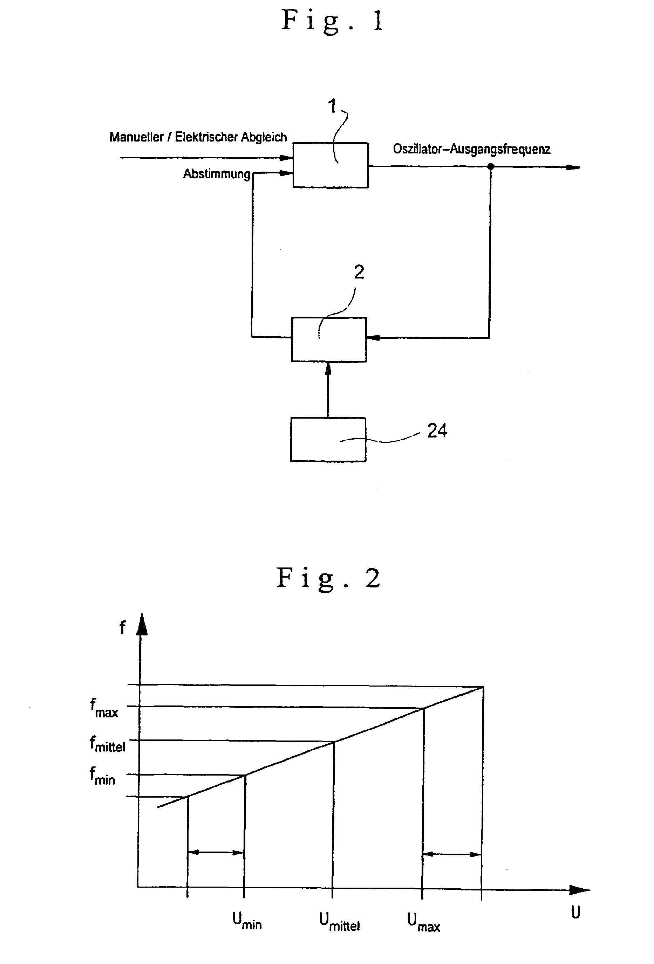

Zum Regeln der Ausgangsfrequenz eines frequenzsteuerbaren Oszillators ist es gemäß Figur 1 bekannt, die Ausgangsfrequenz des Oszillators 1 in einem Frequenzregler, beispielsweise einem Phasendetektor 2, mit einer von einem Referenzfrequenz-Oszillator 24 abgegebenen Referenzfrequenz zu vergleichen und die Phasenabweichung einem Frequenzstellglied des Oszillators als Stellgröße in Form einer als Abstimmung bezeichneten Steuerspannung, Steuerfrequenz oder dergleichen zuzuführen. Das Frequenzstellglied kann aus einer elektrisch abstimmbaren Spule, einer Kapazitätsdiode und/oder einem mechanisch einstellbaren Kondensator oder dergleichen bestehen.

Für den Betrieb des Oszillators ist es von Bedeutung, dass gemäß Figur 2, in der die Oszillator-Ausgangsfrequenz über der Steuerspannung dargestellt ist, eine ausreichende Bandbreite für die Abstimmung bzw. Steuerspannung unter der niedrigsten und über der höchsten Betriebsfrequenz zur Verfügung steht. Zu diesem Zweck wird bei der Inbetriebnahme des Oszillators ein manueller oder elektrischer Abgleich des Frequenzbereichs des Oszillators am Frequenzstellglied oder einem anderen frequenzbestimmenden Stellglied, auf das nicht die Abstimmung zur Regelung der Oszillator-Ausgangsfrequenz einwirkt, durchgeführt, so dass ein hinreichend großer Überschwingraum zu beiden Seiten der Soll- oder Referenzfrequenz besteht. Der Abgleich legt also die Oszillator-Ausgangsfrequenz in einen Bereich, in dem die Bedingung einer ausreichenden Bandbreite für die Steuerspannung, Steuerfrequenz oder dergleichen unter der niedrigsten und über der höchsten Betriebsfrequenz gewährleistet ist.

Dabei bietet ein elektrischer Abgleich Vorteile gegenüber einer mechanischen Einstellung, da ein mechanischer Zugriff auf den Hochfrequenz-Oszillator vermieden wird. Der elektrische Abgleichwert muss bei der Inbetriebnahme des Hochfrequenz-Oszillators ermittelt und in dem Oszillator dauerhaft gespeichert werden, beispielsweise in einem PROM mit nachgeschaltetem Digital-Analog-Wandler.

Durch einen Abgleich des Frequenzbereichs werden starke Schwankungen aufgrund von Bauteil- und Materialtoleranzen bei der Herstellung reduziert bzw. eliminiert und sichergestellt, dass das Frequenzstellglied sowohl die tiefste als auch die höchste Arbeitsfrequenz erreichen kann. Insbesondere bei Anwendung des Oszillators in Nachlaufsynchronisationsschaltungen (Phase Locked Loop, PLL), Frequenznachführungsschaltungen (Frequency Locked Loop, FLL), Schaltungen mit direkter digitaler Synthese (DDS) oder mit digitaler Signalverarbeitung (Digital Signal Processing, DSP) ist eine maximale Mindest- bzw. minimale Höchstfrequenz erforderlich, um den Einschwingvorgang nicht zu behindern.

Unabhängig von der Anwendung des Oszillators und unabhängig davon, ob ein mechanisch einstellbares oder ein elektrisch abgleichbares Frequenzstellglied vorgesehen ist, muss bei der Herstellung ein Abgleichschritt vorgesehen werden, bei dem auch externe Messmittel zum Abgleich sowie Speicherelemente im abzugleichenden Oszillator zur Aufnahme des Abgleichwertes und teure Präzisions-Digital-Analog-Wandler benötigt werden. Dabei ist zusätzlich die Gefahr eines Fehlabgleichs gegeben, insbesondere bei einem manuellen Abgleich des Oszillators.

Im Betrieb des Oszillators besteht zudem die Gefahr einer Langzeitdrift der Frequenzstellglieder, die beispielsweisealterungsbedingt ist, sowie kurzzeitiger Schwankungen des optimalen Abgleichwertes z.B. durch Änderungen der Versorgungsspannung oder der Umgebungsbedingungen, beispielsweise durch Temperaturänderungen. Um den Forderungen nach Temperatur- und Alterungsstabilität des frequenzsteuerbaren Oszillators unter allen Umgebungs- und Alterungsbedingungen zu entsprechen, ist mehrfach ein aufwendiger Nachabgleich bei der Wartung vorzusehen. Dabei erfordert auch ein elektrischer Abgleich zusätzliche Hardware und Software, zusätzlichen Speicherplatz und bindet Kapazitäten in der Entwicklung.

Aus der US 5 382 922 C1 ist ein Phasenregelkreis für einen frequenzsteuerbaren Oszillator bekannt, dessen Ausgangsfrequenz mittels einer Kalibriereinrichtung auf eine Mittenfrequenz eingestellt wird. Der Phasenregelkreis enthält einen Phasenkomparator, an dessen Eingänge eine Referenzfrequenz und die Ausgangsfrequenz des Oszillators angelegt werden und dessen Ausgang über eine Ladungspumpe, einen Filter und einen Spannungs/Strom-Wandler und ein Summationsglied mit dem Frequenzsteuereingang des frequenzsteuerbaren Oszillators verbunden ist.

Zur Einstellung der Mittenfrequenz der vom frequenzsteuerbaren Oszillator abgegebenen Ausgangsfrequenz sind in der Kalibriereinrichtung zwei mit jeweils einer Referenzspannung und einer im Phasenregelkreis abgegriffenen Steuerspannung für den frequenzsteuerbaren Oszillator beaufschlagte Komparatoren vorgesehen, deren Ausgangssignale den Abweichungen der Steuerspannung von den beiden Referenzspannungen entsprechen und an eine Kalibrierlogik abgegeben werden, die mit einem Aufwärts/Abwärts-Zähler verbunden ist, dessen Ausgang über einen Analog/Digital-Wandler ein Abgleichsignal an das mit dem Eingang des frequenzsteuerbaren Oszillators verbundene Summationsglied abgibt. Dabei wird die Kalibrierung der Mittenfrequenz auf eine vorbestimmte Mittenspannung der Oszillator-Steuerspannung innerhalb eines Bereichs möglicher Steuerspannungen in einem stabilen Betrieb des Phasenregelkreises oder alternativ wiederholt und automatisch innerhalb vorgegebener Zeitintervalle durchgeführt, wenn ein stabiler Betrieb des Phasenregelkreises nicht erforderlich ist, so dass die Kalibriereinrichtung es ermöglicht, Bauteiletoleranzen sowie Schwankungen der Temperatur und Versorgungsspannung auszugleichen.

Aus der US-A-4 677 394 ist ein Verfahren zum Kalibrieren eines frequenzsteuerbaren Frequenzgenerators mit einem spannungsgesteuerten Oszillator bekannt, bei dem zum Kompensieren des nichtlinearen Verhaltens des Oszillators der Eingang des Oszillators über ein Summationsglied mit einer Kalibriereinrichtung und über einen Digital/Analog-Wandler mit einem Rechner verbunden ist. Die Kalibriereinrichtung enthält einen einstellbaren Frequenz-Sollwertgeber und eine Reihenschaltung aus einem digitalen Phasendetektor und einem Tiefpass und bildet mit dem auf den Eingang des Phasendetektors zurück gekoppelten Ausgang des Oszillators eine Nachlaufsynchronisationsschaltung (Phase Locked Loop, PLL). Der Rechner erhält digitale Sollwertsignale, die verschiedenen Frequenz-Sollwertsignalen entsprechen, von einem Eingang des Phasendetektors und veranlasst nach Erreichen des eingeschwungenen Zustandes der Nachlaufsynchronisationsschaltung auf das jeweilige Frequenz-Sollwertsignal hin den Digital/Analog-Wandler zur Abgabe einer Steuerspannung für den Oszillator, die der Ausgangsspannung des Tiefpasses vor Beginn des Kalibriervorganges entspricht. Weiterhin wird ein der Steuerspannung entsprechender Digitalwert dem jeweiligen digitalen Sollwertsignal zugeordnet, im Rechner gespeichert und der Eingang des Oszillators von der Kalibriereinrichtung abgetrennt.

Bei diesem bekannten Verfahren wird die Ausgangsspannung des Tiefpasses auf das Erreichen des Wertes Null überwacht und beim Wert Null ein Speicherbefehl für das jeweilige digitale Sollwertsignal und den der Steuerspannung entsprechenden Digitalwert erzeugt. Alternativ wird eine Kalibriereinrichtung mit einem Phasendetektor mit zwei Ausgängen verwendet, dessen beide Ausgangssignale auf Phasengleichheit untersucht werden. Bei Phasengleichheit wird ein Steuerbefehl für das digitale Sollwertsignal und dem der Steuerspannung entsprechenden Digitalwert erzeugt.

Aus der EP 0 910 170 A2 ist ein Phasenregelkreis für einen spannungsgesteuerten Oszillator bekannt, der auf unterschiedliche Ausgangsfrequenzen eingestellt werden kann, die automatisch auf eine Mittenfrequenz abgeglichen werden. Zu diesem Zweck enthält der Phasenregelkreis einen Phasen/Frequenz-Detektor, dem sowohl ein frequenzbestimmendes Eingangssignal als auch das Ausgangssignal des spannungsgesteuerten Oszillators zugeführt wird. Der Phasen/Frequenz-Detektor gibt bei einer Phasenabweichung zwischen dem Eingangssignal und dem rückgekoppelten Ausgangssignal des Oszillatorsein Fehlersignal an eine Ladungspumpe ab, deren Ausgang an einen Schleifenfilter angelegt wird.

Durch die Anordnung mehrerer Schalter am Eingang des spannungsgesteuerten Oszillators und im Schleifenfilter wird zwischen einer Betriebs- und automatischen Abgleichsphase unterschieden, in der eine Referenzspannung an den Eingang des spannungsgesteuerten Oszillators angelegt wird, während in der Betriebsphase die Ausgangsspannung des Schleifenfilters sowohl an den Eingang des spannungsgesteuerten Oszillators als auch über einen Inverter und Komparator an eine Statusvorrichtung angelegt wird, die eine Folge digitaler Steuersignale an den Eingang des spannungsgesteuerten Oszillators anlegt, mit denen unterschiedliche Ausgangsfrequenzen des spannungsgesteuerten Oszillators ausgewählt werden können.

Aufgabe der vorliegenden Erfindung ist es, ein Verfahren zum Regeln der von einem frequenzsteuerbaren Oszillator abgegebenen Ausgangsfrequenz anzugeben und einen frequenzsteuerbaren Oszillator zu schaffen, bei dem ein Fehlabgleich sowie die Notwendigkeit eines manuellen oder elektrischen Abgleichs bei der Herstellung und Inbetriebnahme ausgeschlossen ist und kein Nachabgleich aufgrund von Umgebungs- und Alterungseinflüssen erforderlich ist.

Diese Aufgabe wird erfindungsgemäß durch ein Verfahren mit den Merkmalen des Anspruchs 1 sowie durch einen frequenzsteuerbaren Oszillator mit den Merkmalen des Anspruchs 9 gelöst.

Erfindungsgemäß ist ein Verfahren zum Regeln der von einem frequenzsteuerbaren Oszillator abgegebenen Ausgangsfrequenz, deren Abweichung von einer Soll- oder Referenzfrequenz als Abstimmung an den Oszillator abgegeben wird, wobei beim Abweichen der Abstimmung von einem vorgegebenen Wert ein den Frequenzbereich der Ausgangsfrequenz bestimmendes Abgleichsignal an den Oszillator abgegeben wird, das den Frequenzbereich in vorgebbaren Zeitabständen, fortlaufend und/oder ereignisgesteuert korrigiert, dabei dadurch gekennzeichnet, dass das Abgleichsignal den Abgleich des Oszillators (1) schrittweise oder kontinuierlich so ändert, dass die Abstimmung nach einer vorgegebenen Zeitspanne innerhalb vorgegebener Grenzwerte liegt, wobei
- die Änderung des Abgleichs innerhalb vorgegebener Zeit- oder Ereignisabschnitte verstärkt, verringert oder gesperrt wird und
- die vorgegebenen Grenzwerte der Abstimmung zeit- oder ereignisgesteuert verändert werden.

Die erfindungsgemäße Lösung schließt durch die Regelung eines elektrisch oder mechanisch einstellbaren Frequenzstellgliedes einen Fehlabgleich sowie die Notwendigkeit eines manuellen oder elektrischen Abgleichs bei der Herstellung und Inbetriebnahme eines Oszillators aus und erfordert keinen Nachabgleich aufgrund kurzzeitiger Schwankungen des optimalen Abgleichwertes, z.B. durch Versorgungsspannungsänderungen oder durch Temperatureinflüsse, oder aufgrund langzeitiger Änderungen, beispielsweise durch Alterung frequenzbestimmender Bauteile.

Die erfindungsgemäße Lösung geht von dem Grundgedanken aus, den Abstand zwischen der frequenzbestimmenden Steuergröße bei den extremen Betriebsfrequenzen unter Berücksichtigung der durch den Betriebsspannungsbereich gegebenen Grenzen fortlaufend während des Normalbetriebs zu messen. Nähert sich die Abstimmung zu dicht einer vorgegebenen Grenze, so wird der Abgleich korrigiert. Andernfalls bleibt der Abgleich unverändert erhalten.

Erfindungsgemäß ist hierbei vorgesehen, dass das Abgleichsignal den Abgleich des Oszillators schrittweise oder kontinuierlich so korrigiert, dass die Abstimmung nach einer vorgegebenen Zeitspanne innerhalb vorgegebener Grenzwerte liegt.

Darüber hinaus ist die erfindungsgemäße Lösung dadurch gekennzeichnet, dass die Änderung des Abgleichs innerhalb vorgegebener Zeit- oder Ereignisabschnitte verstärkt oder verringert oder die Änderung des Abgleichs innerhalb vorgegebener Zeit- oder Ereignisabschnitte gesperrt wird. Zusätzlich oder alternativ können die vorgegebenen Grenzwerte der Abstimmung zeit- oder ereignisgesteuert oder die Auswirkung der Grenzwerte der Abstimmung auf die Auslösung gespeicherter Abgleichwerte zeit- oder ereignisgesteuert verändert werden.

Vorzugsweise legt das Abgleichsignal den Frequenzbereich so fest, dass die der minimalen und der maximalen Ausgangsfrequenz zuzuordnende Abstimmung denselben Abstand von einem mittleren Abstimmungswert aufweist.

Eine vorteilhafte Ausgestaltung des erfindungsgemäßen Verfahrens ist dadurch gekennzeichnet, dass die Auslösung der gespeicherten Abgleichwerte auf Zeitabschnitte kurz nach einem Wechsel der Ausgangsfrequenz begrenzt wird.

Um den Lösungsansatz noch weiter zu verbessern, verringert eine Probesequenz nach dem Einschalten viele Änderungen und Anpassungen des Abgleichs während des Normalbetriebs indem die Auslösung der gespeicherten Abgleichwerte während einer Initialisierungsphase nach dem Einschalten des Oszillatorserfolgt.

Eine vorteilhafte Ausgestaltung der erfindungsgemäßen Lösung ist dadurch gekennzeichnet, dass nach dem Einschaltendes Oszillators definierte Ausgangswerte des Abgleichsignals an den Oszillator abgegeben werden. Vorzugsweise wird dabei nach dem Einschalten des Oszillators eine Initialisierungsphase eingefügt, in der zwischen minimalen und maximalen Werten der Schwingfrequenz hin- und hergeschaltet wird. Bei einem Über- oder Unterschreiten der unteren und oberen Grenzwerte der Abstimmung wird ein Abgleichsignal an den Oszillator abgegeben, mit dem der Abgleich des Oszillatorsschrittweise so korrigiert wird, dass vorzugsweise nach einer vorgegebenen Zeitspanne der jeweilige Grenzwert der Abstimmung nicht mehr über- oder unterschritten wird.

Ein mit den erfindungsgemäßen Merkmalen ausgerüsteter frequenzsteuerbarer Oszillator zur Abgabe einer Ausgangsfrequenz innerhalb eines vorgegebenen Frequenzbereichs weist mindestens ein mechanisch oder elektrisch beeinflussbares Frequenzstellglied zum Einstellen der vom Oszillator abgegebenen Ausgangsfrequenz und eine Phasenregelschleife oder Frequenzregeleinrichtung auf, die eine der Abweichung der Ausgangsfrequenz von einer Soll- oder Referenzfrequenz entsprechende Abstimmung an einen Abstimmeingang des Oszillators abgibt, wobei ein mit dem Frequenzstellglied verbundener Abgleicheingang des Oszillators an ein integrierendes Stellglied angeschlossen ist, das über einen Schwellwert-Vergleicher mit der von der Phasenregelschleife abgegebenen Abstimmung beaufschlagt ist. Erfindungsgemäß ist der Oszillator dabei dadurch gekennzeichnet, dass
- das integrierende Stellglied aus einem Analogwert-Speicher oder einem Integratormodul besteht, dessen Ausgang mit einem Steueranschluss des Frequenzstellgliedes des Oszillators verbunden ist,
- eine Vergleichsspannungs- und Zeitsteuereinrichtung mit dem Schwellwert-Vergleicher und/oder mit dem integrierende Stellglied verbunden ist und den Schwellwert-Vergleicher bzw. das integrierende Stellglied zeit- oder ereignisgesteuert beeinflusst, indem sie
   - Änderungen des vom Analogwert-Speicher oder Integratormodul abgegebenen Abgleichsignals während vorgegebener Zeit- oder Ereignisabschnitte verstärkt, verringert oder sperrt und
   - die vorgegebenen Grenzwerte der Abstimmung zeit- oder ereignisgesteuert verändert.

Vorzugsweise besteht der Schwellwert-Vergleicher aus einem Fenster-Diskriminator und die Vergleichsspannungs- und Zeitsteuereinrichtung beeinflusst die Grenzwerte des Fenster-Diskriminators, die Charakteristik des Fenster-Diskriminators in der Nähe der Grenzwerte und/oder die Intensität des Einflusses des Fenster-Diskriminators auf das integrierende Stellglied.

Das Frequenzstellglied kann aus einer Spule mit einstellbarer Induktivität, der eine Kapazitätsdiode und ein in seiner Kapazität steuerbarer (Trimm-) Kondensator parallel geschaltet sind, aufgebaut sein, wobei die Abstimmung mit der Kapazitätsdiode einstellbar und der Abgleich mit dem Trimm-Kondensator veränder- bzw. nachregelbar ist.

Alternativ kann das Frequenzstellglied aus der Parallelschaltung einer Spule mit der Reihenschaltung eines ersten Kondensators, einer Kapazitätsdiode und eines zweiten Kondensators bestehen, wobei an die Verbindung zwischen dem ersten Kondensator und der Kathode der Kapazitätsdiode über einen ersten Widerstand die Abgleichspannung und an die Verbindung der Anode der Kapazitätsdiode mit dem zweiten Kondensator über eine Widerstandskombination die Abstimmspannung angelegt ist.

Anhand eines in der Zeichnung dargestellten Ausführungsbeispieles soll der der Erfindung zugrundeliegende Gedanke näher erläutert werden. Es zeigen:
- Figur 1: ein Blockschaltbild eines frequenzsteuerbaren Oszillators nach dem Stand der Technik;
- Figur 2: eine schematische Darstellung einer Oszillator-Frequenzkennlinie;

- Figur 3: ein Blockschaltbild eines erfindungsgemäß aufgebauten frequenzsteuerbaren Oszillators;
- Figur 4: ein Blockschaltbild der Verbindung eines Schwellwert-Vergleichers mit einem als Integratormodul ausgebildeten integrierenden Stellglied;
- Figur 5: ein Blockschaltbild der Verbindung eines Schwellwert-Vergleichers mit einem Analogwert-Speicher als integrierendem Stellglied;
- Figur 6: eine erste schaltungstechnische Variante eines Frequenzstellgliedes;
- Figur 7: eine zweite schaltungstechnische Variante eines Frequenzstellgliedes und
- Figur 8: eine zeitliche Darstellung der (Abstimm-)Steuerspannung und des Abgleichsignals zur Reglung der Ausgangsfrequenz eines Oszillators bei zu geringer Steuerspannung.

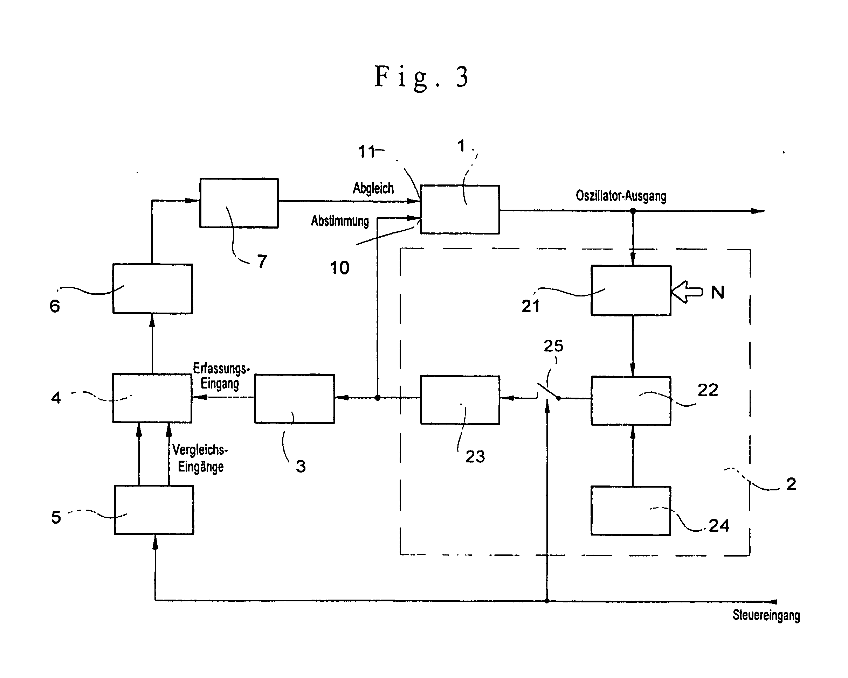

Figur 3 zeigt ein Blockschaltbild der erfindungsgemäßen Lösung mit einem Oszillator 1 mit einem Abstimmeingang 10 und einem Abgleicheingang 11 sowie einem Ausgang zur Abgabe der Oszillator-Ausgangsfrequenz. Der Ausgang ist mit dem Eingang einer Phasenregelschleife 2 verbunden, die einen Frequenzteiler 21, einen Phasendiskriminator 22, einen Referenzfrequenz-Oszillator 24 und einen Schleifenfilter 23 enthält.

Der Ausgang der Phasenregelschleife 2 ist mit dem Abstimmeingang 10 des Oszillators 1 sowie mit einem Tiefpaßfilter 3 verbunden, dessen Ausgang an den Erfassungseingang eines Schwellwert-Vergleichers 4 angeschlossen ist. Der Tiefpaßfilter 3 dient zur Vermeidung einer wechselseitigen Beeinflussung der Phasenregelschleife 2 und der nachgeschalteten Schaltung zum Nachführen bzw. Regeln des Abgleichs. Der Schwellwert-Vergleicher 4 kann aus einem als Fenster-Diskriminator ausgebildeten Komparator bestehen, dessen Ausgang mit dem Eingang eines integrierenden Stellgliedes 6, z.B. eines Integrators oder eines Analogwert-Speichers verbunden ist, dessen Ausgang wiederum über einen Störspannungsfilter 7 an den Abgleicheingang 11 des Oszillators 1 angeschlossen ist.

Die Vergleichseingänge des Fenster-Diskriminators 4 sind an eine Vergleichsspannungs- und Zeitsteuereinrichtung 5 angeschlossen, die über einen Steuereingang mit der Steuereinrichtung einer die Oszillatorschaltung enthaltenden Schaltung verbunden ist.

Die in Figur 3 dargestellte Phasenregelschleife 2 stellt nur ein Beispiel für die Regelung der Ausgangsfrequenz eines Oszillators dar und kann durch andere bekannte Frequenzregler ersetzt werden. Die Aufgabe der als Nachlaufsynchronisationsschaltung ausgebildeten Phasenregelschleife 2 besteht darin, die Ausgangsfrequenz des Oszillators 1 so einzustellen, daß sie mit der vom Referenzfrequenz-Oszillator 24 abgegebenen Referenzfrequenz so genau übereinstimmt, daß die Phasenverschiebung nicht wegläuft. Zu diesem Zweck wird die über den Frequenzteiler 21 an den Phasendiskriminator 22 abgegebene Ausgangsfrequenz des Oszillators 1 mit der Referenzfrequenz verglichen, wobei der Phasendiskriminator 22 eine Ausgangsspannung liefert, die von der Phasenverschiebung zwischen der Ausgangsfrequenz des Oszillators 1 und der Referenzfrequenz des Referenzfrequenz-Oszillator 24 bestimmt wird.

Der Ausgang des Phasendiskriminators 22 ist über einen von dem Steuersignal der zugeordneten Schaltung beeinflußbaren Schalter 25 mit dem Eingang des Schleifenfilters 23 verbunden, dessen Ausgang nach einem Einschwingvorgang der als Nachlaufsynchronisationsschaltung ausgebildeten Phasenregelschleife 2 entsprechend der zu erzeugenden Schwingfrequenz minimale und maximale Werte annimmt.

Der Frequenzteiler 21 verfügt über einen Bereich von N Teilerwerten, wobei der kleinste im Betrieb auftretende Teilerwert der niedrigsten Frequenz entspricht und der höchste Teilerwert der maximalen Frequenz.

Der Schleifenfilter 23 bewirkt eine Verzögerung auf einen Eingangsspannungssprung und schneidet die Überspannungsspitze vom Ausgang der Phasenregelschleife 2 ab. Die vom Ausgang des Schleifenfilters 23 und damit vom Ausgang der Phasenregelschleife 2 abgegebene Stellgröße für die Abstimmung wird zur Nachführung bzw. Regelung der Ausgangsfrequenz des Oszillators 1 über den Tiefpaßfilter 3 dem Schwellwert-Vergleicher 4 zugeführt, der den jeweiligen Abstimmwert mit dem von der Vergleichsspannungs- und Zeitsteuereinrichtung 5 vorgegebenen unteren und oberen Grenzwert vergleicht und ein Unter- bzw. Überschreiten dieser vorgegebenen Grenzwerte ermittelt.

Wenn der Abstimmwert innerhalb eines vorgegebenen Bereiches liegt, ist der Ausgang des Schwellwert-Vergleichers 4 hochohmig. Wenn die die Abstimmung bestimmende Spannung zu klein wird, gibt der Schwellwert-Vergleicher 4 einen definierten Ausgangsstrom ab. Wenn die Spannung zu hoch wird, ist der Ausgangsstrom entgegengestzt gerichtet. Dabei schaltet der Ausgangsstrom des Schwellwert-Vergleichers nicht digital ein- und aus, sondern weist weiche Übergänge von einem Strom Null zu höheren Werten im Bereich der Grenzwertspannung auf.

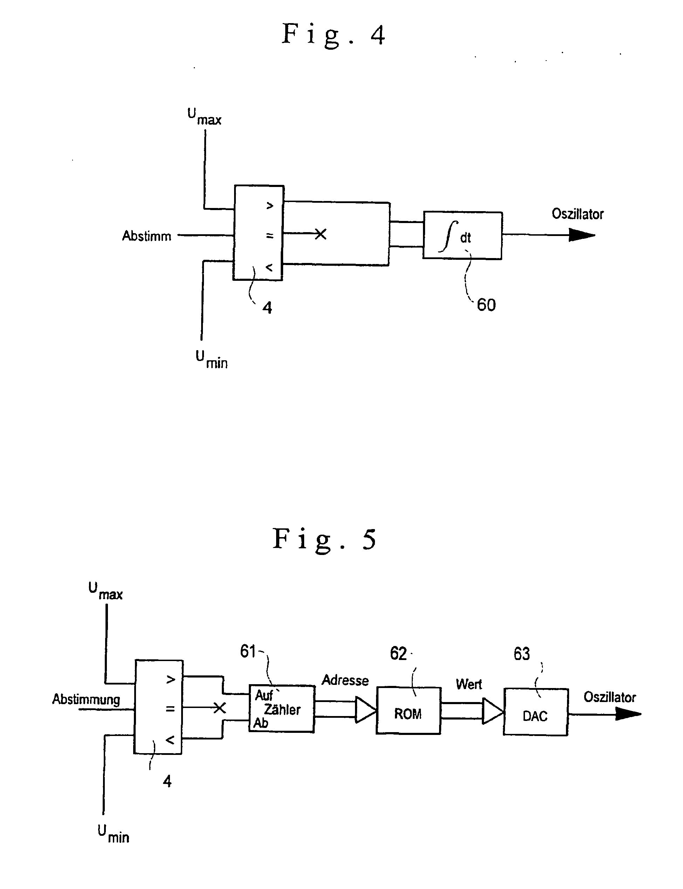

Der Ausgangsstrom des Schwellwert-Vergleichers 4 steuert das integrierende Stellglied 6 an, das gemäß Figur 4 aus einem idealen Integratormodul 60 besteht. Solange der Schwellwert-Vergleicher 4 keinen Ausgangsstrom abgibt, ist die Ausgangsspannung des Integratormoduls 60 konstant. Sobald ein Ausgangsstrom vom Schwellwert-Vergleicher 4 abgegeben wird, steigt die Spannung in Abhängigkeit vom Vorzeichen des Ausgangsstroms des Schwellwert-Vergleichers 4 an oder fällt ab. Je größer der Strom ist, desto steiler ist die Ausgangsspannungsrampe des Integratormoduls 60.

Alternativ kann das integrierende Stellglied 6 aus einem in Figur 5 dargestellten Analogwert-Speicher bestehen, der aus der Reihenschaltung eines Aufwärts/Abwärts-Zählers 61, eines Lesepeichers (ROM) 62 und eines Digital/Analog-Wandlers 63 aufgebaut ist. Der Aufwärts-Zähleingang des Aufwärts/Abwärts-Zählers 61 ist mit dem einen Ausgang des Schwellwert-Vergleichers 4 verbunden, der das Überschreiten eines maximalen Grenzwertes anzeigt und der Abwärts-Zähleingang des Aufwärts/Abwärts-Zählers 61 ist mit dem anderen Ausgang des Schwellwert-Vergleichers 4 verbunden, der das Unterschreiten eines minimalen Grenzwertes anzeigt. Der Ausgang des Aufwärts/Abwärts-Zählers 61 steuert die Adresse des Lesespeichers 62 an, der einen unter dieser Adresse gespeicherten Wert an den Digital/Analog-Wandler 63 abgibt, der gemäß Figur 3 über den Störspannungsfilter 7 das Frequenzstellglied des Oszillators 1 ansteuert.

Das integrierende Stellglied 6 liefert nach dem Einschalten einen definierten Ausgangswert des Abgleichssignals an den Abgleicheingang 11 des Oszillators 1. Dieses Abgleichsignal wird durch das vom Schwellwert-Vergleicher 4 beim Überschreiten oder Unterschreiten der Grenzwerte der Stellgröße für die Abstimmung abgegebene Signal beeinflußt. Durch Veränderung der oberen und unteren Grenzwerte des Schwellwert-Vergleichers 4, der Charakteristiken des Schwellwert-Vergleichers 4 in der Nähe der Grenzwerte sowie die Intensität des Einflusses des Schwellwert-Vergleichers 4 auf das integrierende Stellglied 6 nimmt die Vergleichsspannungs- und Zeitsteuereinrichtung 5 Einfluß auf das an den Oszillator 1 abgegebene Abgleichsignal.

Dieser Einfluß der Vergleichsspannungs- und Zeitsteuereinrichtung 5 auf den Schwellwert-Vergleicher 4 und damit über das integrierende Stellglied 6 auf das Abgleichsignal kann zeit- oder ereignisgesteuert sein, um Änderungen des Abgleichsignals beispielsweise während bestimmter Zeit- oder Ereignisabschnitte zu verstärken, zu verringern oder ganz zu unterbinden. Die Beeinflussung durch die Vergleichsspannungs- und Zeitsteuereinrichtung 5 kann auch auf Zeitabschnitte kurz nach einem Frequenzwechsel des Oszillators 1 begrenzt werden, während bei einer Initialisierungsphase nach dem Einschalten des Oszillators 1 eine durchgängige Beeinflussung des integrierenden Stellgliedes durch die Vergleichsspannungs- und Zeitsteuereinrichtung 5 vorzugsweise vorzusehen ist.

Alternativ zu der in Figur 3 dargestellten Schaltung kann die Vergleichsspannungs- und Zeitsteuereinrichtung 5 auch unmittelbar das integrierende Stellglied 6 ansteuern und damit die Abgabe des Abgleichsignals auf Zeitabschnitte kurz nach einem Frequenzwechsel des Oszillators 1 begrenzen und in einer Initialisierungsphase nach dem Einschalten des Oszillators das integrierende Stellglied 6 durchgängig beeinflussen.

Zur Abstimmung der Ausgangsfrequenz des Oszillators 1 sowie zum Abgleich des Oszillators 1 kann ein einzelnes Frequenzstellglied oder es können mehrere Frequenzstellglieder vorgesehen sein. So können beispielsweise an unterschiedlichen Stellen der Schaltung des Oszillators 1 parallel zu einem LC-Schwingkreis eine geschaltete Kapazitätsdiode, ein mechanisch durch einen Kern mit Stellmotor und Winkelgeber in ihrer Induktivität veränderbare Spule, ein Drehkondensator oder dergleichen angeordnet werden, von denen beispielsweise das eine Frequenzstellglied von der Phasenregelschleife 2 bzw. vom Schleifenfilter 23 und das andere Frequenzstellglied vom integrierenden Stellglied 6 angesteuert wird.

Natürlich läßt die erfindungsgemäße automatische Steuerung wahlweise die Verwendung eines elektrisch oder mechanisch steuerbaren Frequenzstellgliedes im Oszillator 1 zu.

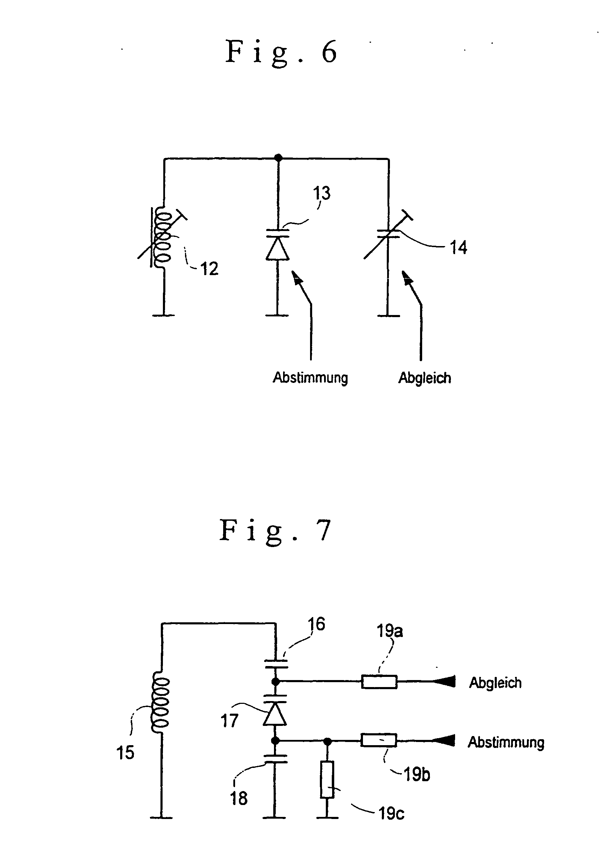

Beispielsweise kann das Frequenzstellglied in der in den Figuren 6 und 7 dargestellten Weise aufgebaut sein und an den Abstimmeingang 10 des Oszillators 1 bzw. an den Ausgang des Schleifenfilters 23 sowie an den Abgleicheingang 11 des Oszillators 1 bzw. Ausgang des Filters 7 angeschlossen werden.

Nach Figur 6 weist das Frequenzstellglied eine Spule 12 mit einstellbarer Induktivität auf, der eine Kapazitätsdiode 13 und ein in seiner Kapazität steuerbarer (Trimm-) Kondensator 14 parallel geschaltet sind. Während die jeweilige Abstimmung mit der Kapazitätsdiode 13 eingestellt wird, dient der Trimm-Kondensator 14 zur Veränderung bzw. zum Nachregeln des Abgleichs.

Gemäß Figur 7 besteht das Frequenzstellglied aus der Parallelschaltung einer Spule 15 mit der Reihenschaltung eines ersten Kondensators 16, einer Kapazitätsdiode 17 und eines zweiten Kondensators 18, wobei an die Verbindung zwischen dem ersten Kondensator 16 und der Kathode der Kapazitätsdiode 17 über einen ersten Widerstand 19a die Abgleichspannung angelegt wird, während an die Verbindung der Anode der Kapazitätsdiode 17 mit dem zweiten Kondensator 18 über eine Widerstandskombination 19b, 19c die Abstimmspannung angelegt ist.

Die in dem Blockschaltbild gemäß Figur 3 dargestellte Schaltung weist folgende Funktion auf.

Nach dem Einschalten des Oszillators 1 kann optional eine Initialisierungsphase eingefügt werden, indem der Frequenzteiler 21 zwischen seinem Minimal- und Maximalwert hin- und hergeschaltet wird. Überschreitet die Stellgröße für die Abstimmung am Ausgang des Schleifenfilters 23 die im Schwellwert-Vergleicher 4 festgelegten unteren bzw. oberen Grenzwerte, so gibt der Schwellwert-Vergleicher 4 ein vorstehend beschriebenes Signal an das integrierende Stellglied 6 ab. Vom Ausgang des integrierenden Stellgliedes 6 werden Abgleichsignale an den Abgleicheingang 11 des Oszillators 1 abgegeben, die den Abgleichwert des im Oszillator 1 integrierten Frequenzstellgliedes schrittweise so korrigieren, daß nach einer bestimmten Zeit der jeweilige Grenzwert des Schwellwert-Vergleichers 4 nicht mehr überschritten wird.

Driftet der Abgleichwert im nachfolgenden Normalbetrieb oder führen z.B. Temperatureinflüsse oder Änderungen der Versorgungsspannung des Oszillators 1 zur Annäherung der Stellgröße für die Abstimmung an einen der im Schwellwert-Vergleicher 4 festgelegten Grenzwerte, so wird der vom integrierenden Stellglied 6 an das Frequenzstellglied abgegebene Abgleichwert entsprechend nachgeführt.

Die durch das integrierende Stellglied 6 in Abhängigkeit von den Steuersignalen der Vergleichsspannungs- und Zeitsteuereinrichtung 5 bzw. der Ausgangssignale des Schwellwert-Vergleichers 4 abgegebenen Abgleichsignale sind auf das Frequenzstellglied des Oszillators 1 abgestimmt, so daß kurzzeitige Schwankungen des optimalen Abgleichwertes z.B. durch Versorgungsspannungsänderungen oder durch Temperatureinflüsse selbst nachgeregelt werden bzw. langzeitige Änderungen z.B. durch Alterung frequenzbestimmender Bauteile selbst korrigiert werden. Damit entfällt ein gegebenenfalls im Service durchzuführender Nachabgleich während der Lebensdauer des Gerätes.

Insbesondere ist aber kein Abgleich bei der Herstellung bzw. der Inbetriebnahme des Oszillators mehr erforderlich und es werden keine externen Meßmittel beim Abgleich benötigt, so daß auch ein eventueller Fehlabgleich ausgeschlossen werden kann.

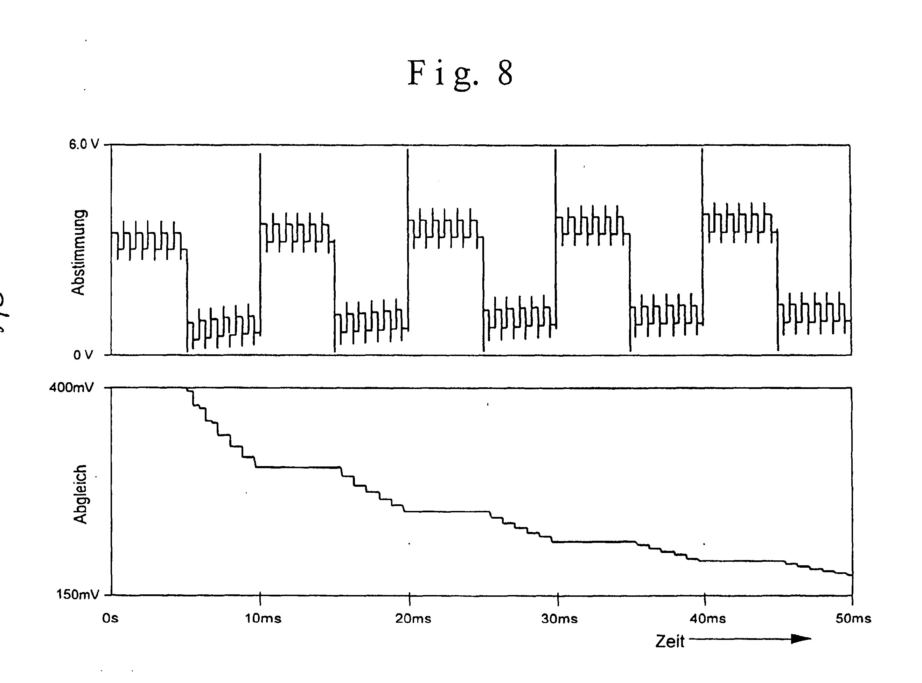

Figur 8 zeigt in der oberen Kurvendarstellung den Verlauf einer Abstimmspannung, die etwa 1 Volt zu niedrig ist. Dies wird deutlich an dem Abschneiden der überschwingenden Minimalamplituden am Anfang jedes Schwingungsblocks. Durch schrittweises Absenken der darunter ebenfalls über der Zeit dargestellten Abgleichspannung wird innerhalb weniger Millisekunden die Hüllkurve der Abstimmspannung so angehoben, daß sie erneut in der Mitte der vorgesehenen Bandbreite liegt.

In gleicher Weise wird bei einer zu hohen Hüllkurve die Abstimmspannung durch Anheben der Abgleichspannung eine Verschiebung der Abstimmspannung in die Mitte der vorgegebenen Grenzwerte bewirkt.

## Patentansprüche

1. Verfahren zum Regeln der von einem frequenzsteuerbaren Oszillator abgegebenen Ausgangsfrequenz, deren Abweichung von einer Soll- oder Referenzfrequenz als Stellgröße für die Abstimmung an den Oszillator abgegeben wird, wobei beim Abweichen der Stellgröße für die Abstimmung von einem vorgegebenen Wert ein den Frequenzbereich der Ausgangsfrequenz bestimmendes Abgleichsignal an den Oszillator abgegeben wird, das den Frequenzbereich in vorgebbaren Zeitabständen, fortlaufend und/oder ereignisgesteuert korrigiert,
**dadurch gekennzeichnet,**
**dass** das Abgleichsignal die Ausgangsfrequenz des Oszillators (1) schrittweise oder kontinuierlich so ändert, dass die Stellgröße für die Abstimmung bei den extremen Betriebsfrequenzen nach einer vorgegebenen Zeitspanne innerhalb durch den Betriebsspannungsbereich gegebener Grenzwerte liegt, wobei
- der Einfluss der Stellgröße für die Abstimmung auf das Abgleichsignal innerhalb vorgegebener Zeit- oder Ereignisabschnitte verstärkt, verringert oder gesperrt wird und
- die vorgegebenen Grenzwerte der Stellgröße für die Abstimmung zeit- oder ereignisgesteuert verändert werden.

2. Verfahren nach Anspruch 1, **dadurch gekennzeichnet, dass** das Abgleichsignal den Frequenzbereich so festlegt, dass die der minimalen und der maximalen Ausgangsfrequenz zuzuordnende Stellgröße für die Abstimmung denselben Abstand von einem mittleren Abstimmungswert aufweist.

3. Verfahren nach Anspruch 1 oder 2, **dadurch gekennzeichnet, dass** die Auswirkung der Grenzwerte der Stellgröße für die Abstimmung auf die Auslösung gespeicherter Werte für das Abgleichsignal zeit- oder ereignisgesteuert verändert wird.

4. Verfahren nach mindestens einem der vorangehenden Ansprüche, **dadurch gekennzeichnet dass** die Auslösung der gespeicherten Werte für das Abgleichsignal auf Zeitabschnitte kurz nach einem Wechsel der Ausgangsfrequenz begrenzt wird.

5. Verfahren nach mindestens einem der vorangehenden Ansprüche, **dadurch gekennzeichnet, dass** die Auslösung der gespeicherten Werte für das Abgleichsignal während einer Initialisierungsphase nach dem Einschalten des Oszillators (1) erfolgt.

6. Verfahren nach mindestens einem der vorangehenden Ansprüche, **dadurch gekennzeichnet, dass** nach dem Einschalten des Oszillators (1) definierte Werte des Abgleichsignals an den Oszillator (1) abgegeben werden.

7. Verfahren nach mindestens einem der vorangehenden Ansprüche, **dadurch gekennzeichnet, dass** die Abstimmung des Ozillators (1) mittels Nachlaufsynchronisation (Phase Locked Loop, PLL), Frequenznachführung (Frequency Locked Loop, FLL), direkter digitaler Synthese (DDS) oder digitaler Signalverarbeitung (Digital Signal Processing, DSP) geregelt wird.

8. Verfahren nach mindestens einem der vorangehenden Ansprüche, **dadurch gekennzeichnet, dass** nach dem Einschalten des Oszillators (1) eine Initialisierungsphase eingefügt wird, in der zwischen minimalen und maximalen Werten der Ausgangsfrequenz hin- und hergeschaltet wird und bei einem Über- oder Unterschreiten der unteren und oberen Grenzwerte der Stellgröße für die Abstimmung der Frequenzbereich des Oszillators (1) so korrigiert wird, dass vorzugsweise nach einer vorgegebenen Zeitspanne der jeweilige Grenzwert nicht mehr über- oder unterschritten wird.

9. Frequenzsteuerbarer Oszillator zur Abgabe einer Ausgangsfrequenz innerhalb eines vorgegebenen Frequenzbereichs mit mindestens einem mechanisch oder elektrisch beeinflussbaren Frequenzstellglied zum Einstellen der vom Oszillator abgegebenen Ausgangsfrequenz und mit einer Phasenregelschleife, die eine der Abweichung der Ausgangsfrequenz von einer Soll- oder Referenzfrequenz entsprechende Stellgröße für die Abstimmung an einen Abstimmeingang des Oszillators abgibt, wobei ein mit dem Frequenzstellglied verbundener Abgleicheingang (11) des Oszillators (1) an ein integrierendes Stellglied (6) angeschlossen ist, das über einen Schwellwert-Vergleicher (4) mit der von der Phasenregelschleife (2) abgegebenen Stellgröße für die Abstimmung beaufschlagt ist,
**dadurch gekennzeichnet,**
**dass**
- das integrierende Stellglied (6) aus einem Analogwert-Speicher (61-63) oder einem Integratormodul (60) besteht, dessen Ausgang mit einem Steueranschluss des Frequenzstellgliedes des Oszillators (1) verbunden ist und das ein den Frequenzbereich der Ausgangsfrequenz bestimmendes Abgleichsignal an den Oszillator(1) abgibt, das den Frequenzbereich in vorgebbaren Zeitabständen, fortlaufend und/oder ereignisgesteuert korrigiert und die Ausgangsfrequenz des Oszillators schrittweise oder kontinuierlich so ändert, dass die Stellgröße für die Abstimmung bei den extremen Betriebsfrequenzen nach einer vorgegebenen Zeitspanne innerhalb durch den Betriebsspannungsbereich gegebener Grenzwerte liegt,
- eine Vergleichsspannungs- und Zeitsteuereinrichtung (5) mit dem Schwellwert-Vergleicher (4) und/oder mit dem integrierenden Stellglied (6) verbunden ist und den Schwellwert-Vergleicher (4) bzw. das integrierende Stellglied (6) zeit- oder ereignisgesteuert beeinflusst, indem sie
- Änderungen des vom Analogwert-Speicher (61-63) oder Integratormodul (60) abgegebenen Abgleichsignals während vorgegebener Zeit- oder Ereignisabschnitte verstärkt, verringert oder sperrt und
- die vorgegebenen Grenzwerte der Stellgröße für die Abstimmung zeit- oder ereignisgesteuert verändert.

10. Frequenzsteuerbarer Oszillator nach Anspruch 9, **dadurch gekennzeichnet, dass** der Schwellwert-Vergleicher (4) aus einem Fenster-Diskriminator (3) besteht und dass die Vergleichsspannungs- und Zeitsteuereinrichtung (5) die Grenzwerte des Fenster-Diskriminators (3), die Charakteristik des Fenster-Diskriminators (3) in der Nähe der Grenzwerte und/oder die Intensität des Einflusses des Fenster-Diskriminators (3) auf das integrierende Stellglied (6) beeinflusst.

11. Frequenzsteuerbarer Oszillator nach Anspruch 9 oder 10, **dadurch gekennzeichnet, dass** der Erfassungseingang des Schwellwert-Vergleichers (4) über einen Tiefpassfilter (3) mit dem Schleifenfilter (23) der Phasenregelschleife (2) verbunden ist.

12. Frequenzsteuerbarer Oszillator nach mindestens einem der Ansprüche 9 bis 11, **dadurch gekennzeichnet, dass** der Analogwert-Speicher aus der Reihenschaltung eines Aufwärts/Abwärts-Zählers (61), eines Speichers (62) und eines Digital/Analog-Wandlers (63) besteht, dass der Aufwärts-Zähleingang des Aufwärts/Abwärts-Zählers (61) mit dem einen Ausgang des Schwellwert-Vergleichers (4) verbunden ist, der das Überschreiten eines maximalen Grenzwertes angibt und der Abwärts-Zähleingang des Aufwärts/Abwärts-Zählers (61) mit dem anderen Ausgang des Schwellwert-Vergleichers (4) verbunden ist, der das Unterschreiten eines minimalen Grenzwertes anzeigt und dass der Ausgang des Aufwärts/Abwärts-Zählers (61) die Adresse des Lesespeichers (62) ansteuert, die einen unter dieser Adresse gespeicherten Wert an den Digital/Analog-Wandler (63) abgibt, der das Frequenzstellglied des Oszillators (1) ansteuert.

13. Frequenzsteuerbarer Oszillator nach mindestens einem der Ansprüche 9 bis 12, **dadurch gekennzeichnet dass** das Frequenzstellglied aus einer Spule (12) mit einstellbarer Induktivität, der eine Kapazitätsdiode (13) und ein in seiner Kapazität steuerbarer (Trimm-) Kondensator (14) parallelgeschaltet sind, besteht und dass die Oszillator-Ausgangsfrequenz mit der Kapazitätsdiode (13) einstellbar ist und der Frequenzbereich mit dem Trimm-Kondensator (14) veränder- bzw. nachregelbar ist.

14. Frequenzsteuerbarer Oszillator nach mindestens einem der Ansprüche 9 bis 13, **dadurch gekennzeichnet, dass** das Frequenzstellglied aus der Parallelschaltung einer Spule (15) mit der Reihenschaltung eines ersten Kondensators (16), einer Kapazitätsdiode (17) und eines zweiten Kondensators (18) besteht, und dass an die Verbindung zwischen dem ersten Kondensator (16) und der Kathode der Kapazitätsdiode (17) über einen ersten Widerstand (19a) eine Abgleichspannung als Abgleichsignal und an die Verbindung der Anode der Kapazitätsdiode (17) mit dem zweiten Kondensator (18) über eine Widerstandskombination (19b, 19c) eine Abstimmspannung als Stellgröße für die Abstimmung angelegt ist.

## Claims

1. Method for regulating the output frequency output by a frequency-controllable oscillator, the deviation of which from a nominal or reference frequency is output to the oscillator as set value for the tuning, wherein, if the set value for the tuning deviates from a predetermined value, an adjustment signal determining the frequency range of the output frequency is output to the oscillator, which signal corrects the frequency range at predeterminable time intervals continuously and/or event-controlled, **characterized in that** the adjustment signal changes the output frequency of the oscillator (1) step-by-step or continuously so that after a predetermined time, at the extreme operating frequencies the set value for the tuning lies within the limit values given by the operating voltage range, wherein
- the influence of the set value for the tuning on the adjustment signal is increased, decreased or blocked within predetermined time or event segments and
- the predetermined limit values of the set value for the tuning are changed in a time-controlled or event-controlled manner.

2. Method according to Claim 1, **characterized in that** the adjustment signal sets the frequency range so that the set value for the tuning to be assigned to the minimum and to the maximum output frequency has the same distance from an average tuning value.

3. Method according to Claim 1 or 2, **characterized in that** the effect of the limit values of the set value for the tuning on the release of stored values for the adjustment signal is changed in a time-controlled or event-controlled manner.

4. Method according to at least one of the preceding claims, **characterized in that** the release of the stored values for the adjustment signal is restricted to time periods shortly after a change to the output frequency.

5. Method according to at least one of the preceding claims, **characterized in that** the release of the stored values for the adjustment signal is performed during an initialization phase following oscillator (1) switch-on.

6. Method according to at least one of the preceding claims, **characterized in that** defined values of the adjustment signal are output to the oscillator (1) following oscillator (1) switch-on.

7. Method according to at least one of the preceding claims, **characterized in that** the tuning of the oscillator (1) is regulated by means of follow-up synchronization (phase locked loop, PLL), frequency correction (frequency locked loop, FLL), direct digital synthesis (DDS) or digital signal processing (DSP).

8. Method according to at least one of the preceding claims, **characterized in that** an initialization phase is inserted following oscillator (1) switch-on, during which phase there is switching back and forth between minimum and maximum values of the output frequency and, if the lower and upper limit values of the set value for the tuning are not attained or exceeded respectively, the frequency range of the oscillator (1) is corrected so that preferably after a predetermined time the respective limit value no longer is exceeded or not attained.

9. Frequency-controllable oscillator for outputting an output frequency within a predetermined frequency range, having at least one mechanically or electrically influenceable frequency control element for adjusting the output frequency output by the oscillator and having a phase-locked loop which outputs a set value for the tuning corresponding to the deviation of the output frequency from a nominal or reference frequency to a tuning input of the oscillator, wherein an adjustment input (11) of the oscillator (1) connected to the frequency control element is connected to an integrating control element (6) to which the set value for the tuning output by the phase-locked loop (2) is applied via a threshold value comparator (4), **characterized in that**
- the integrating control element (6) comprises an analog value memory (61-63) or an integrator module (60), the output of which is connected to a control terminal of the frequency control element of the oscillator (1) and which outputs an adjustment signal determining the frequency range of the output frequency to the oscillator (1), which signal corrects the frequency range in predeterminable time intervals continuously and/or event-controlled and changes the output frequency of the oscillator step-by-step or continuously so that after a predetermined time, at the extreme operating frequencies the set value for the tuning lies within limit values given by the operating voltage range,
- a reference voltage and time control means (5) is connected to the threshold value comparator (4) and/or to the integrating control element (6) and influences the threshold value comparator (4) or the integrating control element (6) in a time-controlled or event-controlled manner, **in that** it
- increases, decreases or blocks during predetermined time or event segments changes of the adjustment signal output by the analog value memory (61-63) or integrator module (60), and
- changes the predetermined limit values of the set value for the tuning in a time-controlled or event-controlled manner.

10. Frequency-controllable oscillator according to Claim 9, **characterized in that** the threshold value comparator (4) comprises a window discriminator (3), and **in that** the reference voltage and time control means (5) influences the limit values of the window discriminator (3), the characteristic of the window discriminator (3) in the proximity of the limit values and/or the intensity of the influence of the window discriminator (3) on the integrating control element (6).

11. Frequency-controllable oscillator according to Claim 9 or 10, **characterized in that** the measurement input of the threshold value comparator (4) is connected via a low-pass filter (3) to the loop filter (23) of the phase-locked loop (2).

12. Frequency-controllable oscillator according to at least one of Claims 9 to 11, **characterized in that** the analog value memory comprises the series connection of an up/down counter (61), a memory (62) and a digital/analog converter (63), **in that** the incrementing input of the up/down counter (61) is connected to the one output of the threshold value comparator (4) which indicates if a maximum limit value is exceeded, and the decrementing input of the up/down counter (61) is connected to the other output of the threshold value comparator (4) which indicates if a minimum limit value has not been attained, and **in that** the output of the up/down counter (61) activates the address of the read memory (62) which outputs a value stored at this address to the digital/analog converter (63), which activates the frequency control element of the oscillator (1).

13. Frequency-controllable oscillator according to at least one of Claims 9 to 12, **characterized in that** the frequency control element comprises a coil (12) with adjustable inductance, connected in parallel with which are a capacitance diode (13) and a (trimming) capacitor (14) whose capacitance can be controlled, and **in that** the oscillator output frequency can be adjusted with the capacitance diode (13), and the frequency range can be changed or corrected using the trimming capacitor (14).

14. Frequency-controllable oscillator according to at least one of Claims 9 to 13, **characterized in that** the frequency control element comprises the parallel connection of a coil (15) to the series connection of a first capacitor (16), a capacitance diode (17) and a second capacitor (18), and **in that** an adjustment voltage is applied as adjustment signal to the connection between the first capacitor (16) and the cathode of the capacitance diode (17) via a first resistor (19a), and the tuning voltage is applied as set value for the tuning to the connection of the anode of the capacitance diode (17) to the second capacitor (18) via a resistor combination (19b, 19c).

## Revendications

1. Procédé de régulation de la fréquence de sortie délivrée par un oscillateur commandable en fréquence, dont l'écart par rapport à une fréquence de consigne ou de référence est délivré à l'oscillateur en tant que grandeur de commande pour l'accord, un signal de compensation déterminant la plage de fréquences de la fréquence de sortie étant délivré à l'oscillateur en cas d'écart de la grandeur de commande pour l'accord par rapport à une valeur prédéfinie, lequel corrige la plage de fréquence à des intervalles de temps pouvant être prédéfinis continuellement et/ou en fonction d'un événement, **caractérisé en ce que** le signal de compensation modifie la fréquence de sortie de l'oscillateur (1) pas à pas ou continuellement de telle sorte que la grandeur de commande pour l'accord, en présence des fréquences de fonctionnement extrêmes, se trouve après un intervalle de temps prédéfini entre des valeurs limites données par la plage de tension de fonctionnement,
- l'influence de la grandeur de commande pour l'accord sur le signal de compensation étant amplifiée, réduite ou bloquée au sein de portions de temps ou d'événement prédéfinies
et
- les valeurs limites prédéfinies de la grandeur de commande pour l'accord étant modifiées en fonction du temps ou de l'événement.

2. Procédé selon la revendication 1, **caractérisé en ce que** le signal de compensation définit la plage de fréquences de telle sorte que la grandeur de commande pour l'accord à affecter à la fréquence de sortie minimale et maximale présente le même écart par rapport à une valeur d'accord moyenne.

3. Procédé selon la revendication 1 ou 2, **caractérisé en ce que** l'effet des valeurs limites de la grandeur de commande pour l'accord sur la libération des valeurs enregistrées pour le signal de compensation est modifié en fonction du temps ou de l'événement.

4. Procédé selon au moins l'une des revendications précédentes, **caractérisé en ce que** la libération des valeurs enregistrées pour le signal de compensation est limitée aux portions de temps juste après un changement de la fréquence de sortie.

5. Procédé selon au moins l'une des revendications précédentes, **caractérisé en ce que** la libération des valeurs enregistrées pour le signal de compensation a lieu pendant une phase d'initialisation après la mise en marche de l'oscillateur (1).

6. Procédé selon au moins l'une des revendications précédentes, **caractérisé en ce qu'**après la mise en marche de l'oscillateur (1), des valeurs définies du signal de compensation sont délivrées à l'oscillateur (1).

7. Procédé selon au moins l'une des revendications précédentes, **caractérisé en ce que** l'accord de l'oscillateur (1) est régulé au moyen d'une synchronisation par poursuite (boucle à verrouillage de phase, PLL), d'un suivi de la fréquence (boucle à verrouillage de fréquence, FLL), de la synthèse numérique direct (DDS) ou d'un traitement numérique du signal (DSP).

8. Procédé selon au moins l'une des revendications précédentes, **caractérisé en ce qu'**après la mise en marche de l'oscillateur (1) est initiée une phase d'initialisation dans laquelle la fréquence de sortie est basculée çà et là entre des valeurs minimale et maximale et, en cas de franchissement dans un sens ou dans l'autre de la valeur limite supérieure et inférieure, la grandeur de commande pour l'accord de la plage de fréquences de l'oscillateur (1) est corrigée de telle sorte que la valeur limite correspondante n'est plus franchie de préférence après un intervalle de temps prédéfini.

9. Oscillateur commandable en fréquence destiné à délivrer une fréquence de sortie au sien d'une plage de fréquences prédéfinie, comprenant au moins un élément de réglage de la fréquence pouvant être influencé mécaniquement ou électriquement pour régler la fréquence de sortie délivrée par l'oscillateur et comprenant une boucle de régulation de phase qui délivre à une entrée d'accord de l'oscillateur une grandeur de commande pour l'accord correspondant à l'écart entre la fréquence de sortie et une fréquence de consigne ou de référence, une entrée de compensation (11) de l'oscillateur (1) reliés avec l'élément de réglage de la fréquence étant raccordée à un élément de réglage (6) intégratif auquel peut être appliquée la grandeur de commande pour l'accord délivrée par la boucle de régulation de phase (2) par le biais d'un comparateur de valeur de seuil (4), **caractérisé en ce que**
- l'élément de commande intégratif(6) se compose d'une mémoire à valeur analogique (61-63) ou d'un module intégrateur (60) dont la sortie est reliée avec une borne de commande de l'élément de réglage de la fréquence de l'oscillateur (1) et qui délivre à l'oscillateur (1) un signal de compensation qui détermine la plage de fréquences de la fréquence de sortie, qui corrige la plage de fréquences continuellement et/ou en fonction d'un événement à des intervalles de temps pouvant être prédéfinis et modifie la fréquence de sortie de l'oscillateur pas à pas ou continuellement de telle sorte que la grandeur de commande pour l'accord, en présence des fréquences de fonctionnement extrêmes, se trouve après un intervalle de temps prédéfini entre des valeurs limites données par la plage de tension de fonctionnement,
- un dispositif de commande par tension de comparaison et par temps (5) est en liaison avec le comparateur de valeur de seuil (4) et/ou avec l'élément de commande intégratif (6) et influence le comparateur de valeur de seuil (4) ou l'élément de commande intégratif (6) en fonction du temps ou d'un événement en
- amplifiant, réduisant ou bloquant au sein de portions de temps ou d'événement prédéfinies changements du signal de compensation délivré par la mémoire à valeur analogique (61-63) ou le module intégrateur (60) et
- modifiant les valeurs limites prédéfinies de la grandeur de commande pour l'accord en fonction du temps ou d'un événement.

10. Oscillateur commandable en fréquence selon la revendication 9, **caractérisé en ce que** le comparateur de valeur de seuil (4) se compose d'un discriminateur à fenêtre (3) et que le dispositif de commande par tension de comparaison et par temps (5) influence les valeurs limites du discriminateur à fenêtre (3), la caractéristique du discriminateur à fenêtre (3) à proximité des valeurs limites et/ou l'intensité de l'influence du discriminateur à fenêtre (3) sur l'élément de commande intégratif (6).

11. Oscillateur commandable en fréquence selon la revendication 9 ou 10, **caractérisé en ce que** l'entrée d'acquisition du comparateur de valeur de seuil (4) est reliée par le biais d'un filtre passe-bas (3) avec le filtre de boucle (23) de la boucle de régulation de phase (2).

12. Oscillateur commandable en fréquence selon au moins l'une des revendications 9 à 11, **caractérisé en ce que** la mémoire à valeur analogique se compose du circuit série constitué d'un compteur/décompteur (61), d'une mémoire (62) et d'un convertisseur numérique/analogique (63), que l'entrée comptage du compteur/décompteur (61) est reliée avec une entrée du comparateur de valeur de seuil (4) qui indique le dépassement d'une valeur limite maximale et l'entrée décomptage du compteur/décompteur (61) est reliée avec l'autre entrée du comparateur de valeur de seuil (4) qui indique le franchissement vers le bas d'une valeur limite minimale et que la sortie du compteur/décompteur (61) commande l'adresse de la mémoire de lecture (62) qui délivre une valeur enregistrée sous cette adresse au convertisseur numérique/analogique (63), qui commande l'élément de réglage de la fréquence de l'oscillateur (1).

13. Oscillateur commandable en fréquence selon au moins l'une des revendications 9 à 12, **caractérisé en ce que** l'élément de réglage de la fréquence se compose d'une bobine (12) à inductance réglable en parallèle de laquelle sont branchés une diode à capacité variable (13) et un condensateur (d'accord) (14) à capacité réglable et que la fréquence de sortie de l'oscillateur est réglable avec la diode à capacité variable (13) et la plage de fréquence peut être modifiée ou réajustée avec le condensateur d'accord (14).

14. Oscillateur commandable en fréquence selon au moins l'une des revendications 9 à 13, **caractérisé en ce que** l'élément de réglage de la fréquence se compose du circuit parallèle constitué d'une bobine (15) et du circuit série composé d'un premier condensateur (16), d'une diode à capacité variable (17) et d'un deuxième condensateur (18), et qu'une tension de compensation faisant office de signal de compensation est appliquée au point de liaison entre le premier condensateur (16) et la cathode de la diode à capacité variable (17) par le biais d'une première résistance (19a) et qu'une tension d'accord sous la forme d'une grandeur de commande pour l'accord est appliquée au point de liaison de l'anode de la diode à capacité variable (17) avec le deuxième condensateur (18) par le biais d'une combinaison de résistances (19b, 19c).
